# EUROPEAN PATENT SPECIFICATION

(11) **EP 0 326 254 B1**
(45) Date of publication and mention of the grant of the patent: **24.05.1995**
(21) Application number: 89300342.6
(22) Date of filing: 13.01.1989
(51) Int. Cl.: G11C 7/00, G11C 11/22, G09G 3/36

(54) **Apparatus for and method of addressing data storage elements**
Verfahren und Anordnung zur Adressierung von Datenspeicherelementen
Appareil et méthode d'adressage d'éléments d'emmagasinage de données

(30) Priority: 19.01.1988 US 145061
(43) Date of publication of application: 02.08.1989
(73) Proprietor: TEKTRONIX, INC., Wilsonville, Oregon 97070-1000 (US)
(72) Inventor: Buzak, Thomas S., Beaverton Oregon 97007 (US)
(74) Representative: Burke, Steven David

(56) References cited:
- US-A- 2 847 615

## Description

The present invention relates to systems constructed of data storage elements and, in particular, to apparatus for and methods of addressing an array of such storage elements with the use of an ionizable gas.

Systems employing data storage elements include, for example, video cameras and image displays. Such systems employ an addressing structure that provides data to or retrieves data from the storage elements. One system of this type to which one embodiment of the present invention is particularly directed is a general purpose flat panel display, whose storage or display elements store light pattern data. A flat panel display comprises multiple display elements distributed throughout the viewing area of a display surface. A flat panel display system is desirable because it does not necessarily require a cathode-ray tube to develop a display image. A cathode-ray tube is undesirable because of its size, fragility, and need for high voltage drive circuitry.

One type of flat panel display system employs an addressing structure that accomplishes direct multiplexing of multiple liquid crystal cells or display elements arranged in an array. Each of the liquid crystal cells is positioned between a pair of electrical conductors that selectively apply select and deselect voltage signals across the liquid crystal cell to change its optical properties and thereby change the brightness of the image it develops. A display system of this type is characterized as "passive" because no "active" electronic device cooperates with the liquid crystal cell to modify its electro-optical properties. Such a display system suffers from the disadvantage of being capable of implementation with only a limited number of addressable lines (i.e., up to about 250) of video information or data for developing a display image.

One expedient for increasing the number of addressable lines of data in a liquid crystal display system entails the use of an addressing structure in which a separate electronic device cooperates with each liquid crystal cell to increase the effective nonlinearity of its electro-optic response to the select and deselect voltage signals. Some of what are referred to as "two-terminal" device addressing techniques can be characterized in this way. Although increasing the effective nonlinearity of a display element may allow greater multiplexing capabilities in a bilevel display, there remain many difficulties with this technique in respect to achieving gray scale performance.

The objective in designing liquid crystal matrix display systems having full gray scale capability is to provide an addressing structure that does not rely on obtaining the nonlinearity function from the liquid crystal material. An addressing structure that uses a matrix of electrically "active" elements accomplishes this objective by employing at each picture element an electronic switch that is separate from the liquid crystal material. The active matrix uses two- or three-terminal solid state devices in association with each liquid crystal cell to develop the needed nonlinearity and display element isolation. Addressing structures constructed of two-terminal devices can employ diodes of various types, and addressing structures constructed of three-terminal devices can employ thin film transistors (TFT) of various types manufactured from different semiconductor materials.

One problem with two- and three-terminal active matrices is that the very large number of active devices makes it very difficult to fabricate the matrix in large quantities with high production yields. Another problem, which is characteristic of TFT devices, is the difficulty of constructing thin film transistors with sufficiently high "off resistances." A relatively low "off resistance" provides a display element that may not hold the charge developed across it for the requisite time. A relatively low "off resistance" also decreases the "off resistance" to "on resistance" ratio, which preferably exceeds 10⁶ to promote proper operation of the TFT matrix. TFT matrices sometimes employ a separate storage capacitor with each display element to offset the effect of an insufficiently high "off resistance." The use of separate storage capacitors increases, however, the complexity of the TFT matrix incorporating them and the likelihood of decreased production yields. One other possible problem with a TFT active matrix is that the size of a TFT can be relatively large compared to that of the display element because "on" current requirements tend to increase the dimensions of a TFT device. This may affect the light efficiency of the device.

An active matrix formed of TFT devices is capable of developing black-and-white and colored images. To develop colored images, the active matrix employs a color filter containing multiple groups of spots in different colors spatially aligned with the display elements. A group of display elements aligned with spots of different colors would, therefore, define a single image pixel.

Flat panel display systems can also be implemented with display elements employing an ionizable gas or plasma that glows to produce on a display surface luminous regions whose color is characteristic of the type of gas used. The luminous regions are selectively activated to form a display image.

Another type of flat panel display system employs a plasma to generate electrons that are accelerated to strike a phosphor and produce a luminescent spot. Such a flat panel display provides increased efficiency in brightness but is difficult to produce with large display areas and requires complex drive circuits. Such flat panel displays can be constructed with multiple electron-excited phosphors having different spectral characteristics to provide multi-colored images.

Problems with gas-plasma flat panel displays are purportedly alleviated through the use of gas-discharge displays of the plasma-sac type. In such displays, a plasma-sac produced on the cathode side of an apertured insulator moves from one aperture to another to effect a raster-type scan. The plasma-sac-type gas-discharge displays are also complex to fabricate and are susceptible to low production yields.

The document US-A-2 847 615 discloses a memory device (see preamble of claims 1 and 13) including a plurality of gaseous discharge channels, each channel having a single electrode mounted along it. Ionization is effected by exciting the electrode with a high voltage RF signal.

According to one aspect of the present invention, there is provided an addressing structure for a data storage element, comprising: an ionizable gaseous medium adapted for communication with the data storage element and an electrical reference electrode positioned within the gaseous medium; and ionizing means for selectively effecting ionization of the ionizable gaseous medium to provide an interruptible electrical connection between the data storage element and the electrical reference electrode, thereby to selectively address the data element, characterised in that the ionizing means comprises an ionizing electrode positioned adjacent the reference electrode within the gaseous medium, whereby ionization of the gaseous medium is effected by application of a signal between the ionizing electrode and the reference electrode.

According to another aspect of the present invention, there is provided a method of addressing a data element, comprising: positioning an electrical reference electrode within an ionizable gaseous medium; and providing an interruptible electrical connection between the electrical reference electrode and the data element by selectively effecting ionization of the ionizable gaseous medium in communication with the data element, the ionization of the gaseous medium developing an electrical conduction path through the gaseous medium to the electrical reference electrode to address the data element to which a datum corresponds, characterised by positioning an ionizing electrode within the ionizable gaseous medium and in that the ionization is effected by selectively applying a signal between said ionizing and reference electrodes. A similar invention, that differs only slightly from the invention defined in claim 1 is claimed in copending application EP-A-0 325 387.

Embodiments of the present invention advantageously provide a system employing data elements implemented as part of an addressing structure that can be produced at low cost with high production yields.

Embodiments of this invention provide a method that employs an ionizable gaseous medium to address a data storage element so that data can be read into or retrieved from it.

An advantage of embodiments of this invention is that they provide a flat panel display system with high-speed addressing capabilities and high contrast characteristics and having storage or display elements comprised of an electro-optic material and an active addressing structure.

Embodiments of this invention may provide such a display system in which an electro-optic material cooperates with an ionizable gas to form addressable data storage elements.

Such a display system may have good colour, grey scale, and brightness characteristics.

The invention is described herein only by way of example with reference to two embodiments.

The first embodiment comprises an addressing structure implemented in a high resolution flat panel display system that can be used in either direct view or projection applications. The display system includes a display panel having a display surface formed of an array of data storage or display elements distributed throughout the viewing area thereof. Each of the display elements comprises a localised volume of ionizable gas, such as helium, and an electro-optic material, such as a nematic liquid crystal, that cooperate to modulate externally generated light propagating through the region of the electro-optic material where the display element is located.

The second embodiment comprises an addressing structure implemented as part of a memory device into which and out of which analog information can be, respectively, electronically written or electronically read. The memory device includes an array of data storage or memory elements each of which includes a localized volume of ionizable gas, such as helium, and a dielectric material, such as glass, plastic, or photoconductor. The ionizable gas and dielectric material cooperate to provide a way of addressing the memory element to read out a signal previously developed across the memory element, irrespective of the manner in which it acquired the signal.

The storage elements are arranged in columns and rows for both embodiments. In the first embodiment, a row represents one line of video information or data, and in the second embodiment, a row represents a set of discrete quantities of analog information or data. (The information addressed in either embodiment is hereafter referred to as "data"). The columns receive the data, and a data strobe circuit addresses the columns row by row in a row scan fashion.

Either the display panel of the first embodiment or the memory device of the second embodiment comprises first and second spaced-apart substrates positioned face-to-face to each other. Multiple nonoverlapping electrical conductors extending generally in a first direction along the inner surface of the first substrate form column electrodes for data drive signals applied to them. Multiple nonoverlapping channels inscribed into the inner surface of the second substrate extend along the inner surface in a direction generally transverse to the first direction. The first and second directions preferably align with the vertical and horizontal directions, respectively. A reference potential electrode and a row electrode electrically isolated from each other extend along the length of the interior of each channel and receive data strobe signals applied to them. Each of the channels is filled with the ionizable gas.

In the display panel of the first embodiment, a layer of material having electro-optical properties and a layer of dielectric material are positioned between the inner surfaces of the first and second substrates, the layer of dielectric material covering the channels to form a barrier between the layer of the electro-optic material and the ionizable gas. The display elements are defined by the overlapping areas of the column electrodes and the channels and appear as spots on the display screen. The spots are sufficiently small and positioned close to one another so that they are indistinguishable by an observer during normal viewing conditions.

The display panel is configured as described above so that for each display element, the ionizable gas functions as an electrical switch that changes between a conducting or plasma state and a nonconducting or de-ionized state in response to an applied data strobe signal. The magnitude of the data drive signal on the column electrodes corresponds to the luminance of a display image.

Whenever it is in the conducting state, a region of ionized gas allows a data voltage of a magnitude representing that of a data drive signal to develop across the liquid crystal material in a region spatially aligned with the region of ionized gas. Whenever it changes to the nonconducting state, the region of de-ionized gas allows the spatially aligned region of liquid crystal material to hold the data voltage across it for a time. The ionizable gas functions, therefore, to select and store data across the liquid crystal material and thereby provide a display system having gray scale luminance.

Switching the ionizable gas between the conducting state and the nonconducting state in the display panel modulates the light transmission through a display element. The modulation of light transmission depends on the magnitude of the applied data drive signal. A monochrome or black-and-white display system with gray scale luminance qualities can be implemented with the use of the display panel. A full color display system with controllable color intensity can be implemented by positioning within the black-and-white display system a color filter containing groups of spots in three primary colors spatially aligned with the display elements. A group of three display elements spatially aligned with a group of spots would, therefore, represent one image pixel whose color is determined by the relative intensities of the spots in the group.

The display system of the present invention is capable of rendering fully dynamic, gray scale images over a broad range of field rates to provide a quality display. The display system is especially advantageous because it is of simple, rugged construction and is capable of addressing at least 3,000 lines of data at 60 Hz field rates on the display screen.

In the memory device of the second embodiment, only a layer of dielectric material is positioned between the first and second substrates. The memory elements are defined by the overlapping areas of the column electrodes and the channels. The memory device is configured as described above so that for each memory element, the ionizable gas functions as an electrical switch that changes between the conducting state and the nonconducting state in response to the applied data strobe signal. Amplifiers providing the data drive signals are configured as column electrode drive amplifiers in a data write mode and as column electrode sensing amplifiers in a data read mode.

Whenever it is in the conducting state, a region of ionized gas allows a data voltage of a magnitude representing that of a data drive signal to develop across the dielectric material in a region spatially aligned with the region of ionized gas. This represents the data write mode of the memory device. Whenever it changes to the nonconducting state, the region of de-ionized gas allows the spatially aligned dielectric material to hold the data voltage across it for a time. The column electrode sensing amplifier associated with the region applies a reference voltage to a surface of the layer of dielectric material opposite the surface spatially aligned with the region of ionized gas. Whenever it returns to the conducting state, the region of ionized gas causes a change in the voltage across the dielectric material which change is proportional to the previously written data voltage and appears at the output of the column electrode sensing amplifier. This represents the data read mode of the memory device.

Certain modifications of the addressing structure described above could facilitate other means for applying the data voltage to the memory elements of the memory device. For example, substituting a photoconductive material for the dielectric material and using column electrodes having optically transparent properties would permit incident light to modulate the magnitude of the data voltages applied to the memory element in proportion to the intensity of incident light. Such an addressing structure could be implemented as part of an image sensing device or optical processing device.

Additional objects and advantages of the present invention will be apparent from the detailed description of preferred embodiments thereof, which proceeds with reference to the accompanying drawings, in which:

Fig. 1 is a diagram showing a frontal view of the display surface of a display panel and associated drive circuitry of a display system embodying the present invention.

Fig. 2 is an enlarged fragmentary isometric view showing the layers of structural components forming the display panel embodying the present invention as viewed from the left side in Fig. 1.

Fig. 3 is an enlarged fragmentary frontal view with portions broken away to show different depthwise views of the interior of the display panel of Fig. 2.

Fig. 4 is a sectional view taken along lines 4--4 of Fig. 3.

Fig. 5 is a sectional view taken along lines 5--5 of Fig. 3.

Fig. 6 is an equivalent circuit showing for a display system the operation of the plasma as a switch for an exemplary row receiving a data strobe pulse and three exemplary data columns receiving a data drive signal.

Fig. 7 is a diagram showing the various time constraints that determine the maximum number of lines of data that are addressable by a display system embodying the present invention.

Fig. 8 is a graph showing the comparative relationship of the data capture times of neon gas and helium gas as a function of the current flowing between the electrodes positioned within the channels of the display panel of Figs. 2-5.

Fig. 9 is a graph showing for data strobe pulses of different magnitudes the plasma decay times for helium gas as a function of the current that was flowing during the strobe pulse between the electrodes positioned within the channels of the display panel of Figs. 2-5.

Figs. 10A and 10B are diagrams of alternative electronic circuit designs of the data driver shown in Fig. 1.

Figs. 11A and 11B are diagrams of alternative channel electrode wiring configurations that illustrate a technique for reducing the required number of outputs of the data strobe of Fig. 1.

Fig. 12 is a graph showing the minimum number of drivers required as a function of the available number of addressable lines of data for a channel electrode wiring configuration of the type shown in Fig. 11B.

Fig. 13 is an equivalent circuit showing the operation of the plasma as a switch in cooperation with the data drive circuit to form an addressing structure for selectively writing data into and reading data out of a memory element.

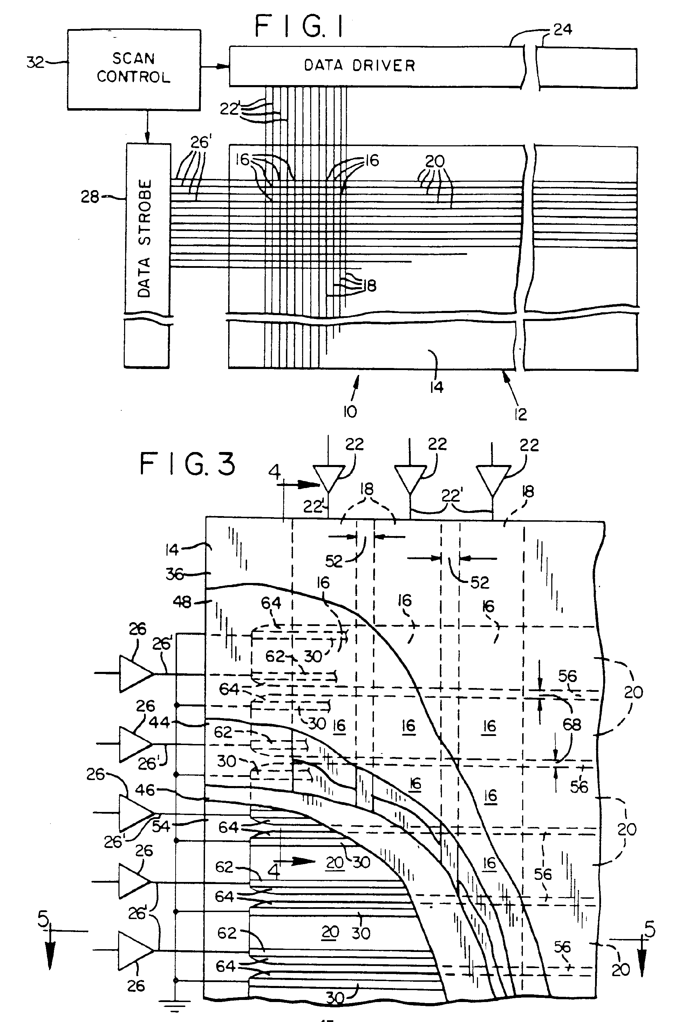

Fig. 1 shows a flat panel display system 10, which represents a first embodiment that implements the addressing structure and carries out the addressing method of the present invention. With reference to Fig. 1, flat panel display system 10 comprises a display panel 12 having a display surface 14 that contains a pattern formed by a rectangular planar array of nominally identical data storage or display elements 16 mutually spaced apart by predetermined distances in the vertical and horizontal directions. Each display element 16 in the array represents the overlapping portions of thin, narrow electrodes 18 arranged in vertical columns and elongate, narrow channels 20 arranged in horizontal rows. (The electrodes 18 are hereinafter referred to as "column electrodes 18.") The display elements 16 in each of the rows of channels 20 represent one line of data.

The widths of column electrodes 18 and channels 20 determine the dimensions of display elements 16, which are of rectangular shape. Column electrodes 18 are deposited on a major surface of a first electrically nonconductive, optically transparent substrate, and channels 20 are inscribed in a major surface of a second electrically nonconductive, optically transparent substrate, as will be further described below. Skilled persons will appreciate that certain systems, such as a reflective display of either the direct view or projection type, would require that only one of the substrates be optically transparent.

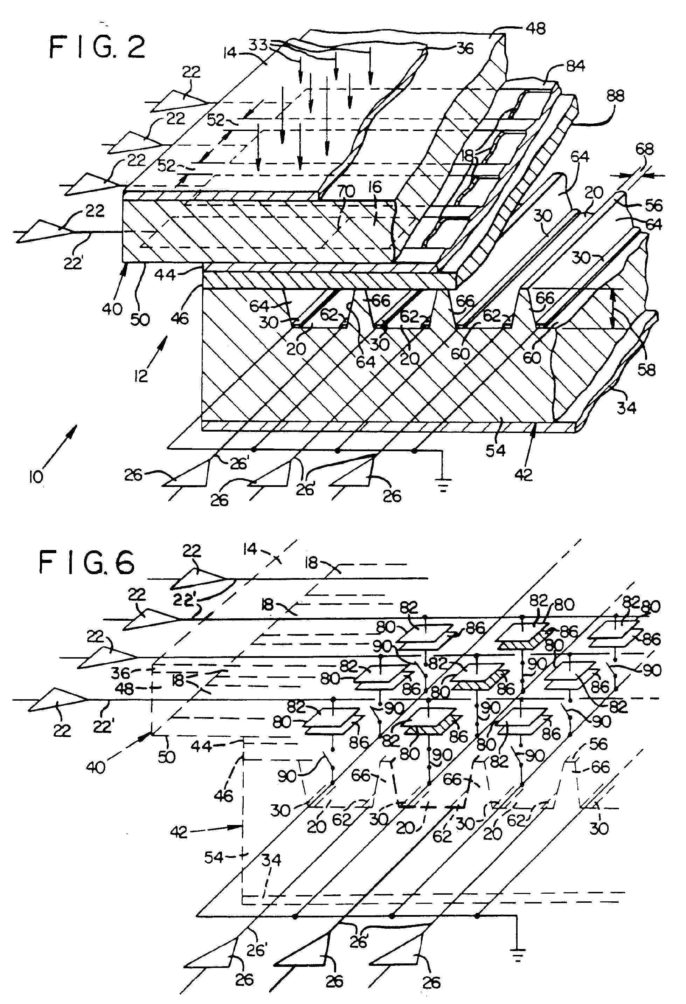

Column electrodes 18 receive data drive signals of the analog voltage type developed on parallel output conductors 22′ by different ones of the output amplifiers 22 (Figs. 2-6) of a data drive means or circuit 24, and channels 20 receive data strobe signals of the voltage pulse type developed on parallel output conductors 26′ by different ones of the output amplifiers 26 (Figs. 2-6) of a data strobe means or circuit 28. Each of the channels 20 is connected to a reference electrode 30 (Fig. 2) to which a reference potential common to each channel 20 and data strobe 28 is applied.

To synthesize an image on the entire area of display surface 14, display system 10 employs a scan control circuit 32 that coordinates the functions of its data driver 24 and data strobe 28 so that all columns of display elements 16 of display panel 12 are addressed row by row in row scan fashion. Display panel 12 may employ electro-optic materials of different types. For example, if it uses such a material that changes the polarization state of incident light rays 33, display panel 12 is positioned between a pair of light polarizing filters 34 and 36 (Fig. 2), which cooperate with display panel 12 to change the luminance of light propagating through them. The use of a scattering liquid crystal cell as the electro-optic material does, however, not require the use of polarizing filters 34 and 36. A color filter (not shown) may be positioned within display panel 12 to develop multi-colored images of controllable color intensity. For a projection display, color can also be achieved by using three separate monochrome panels 10, each of which controls one primary color.

With reference to Figs. 2-5, display panel 12 comprises an addressing structure that includes a pair of generally parallel electrode structures 40 and 42 spaced apart by a layer 44 of electro-optic material, such as a nematic liquid crystal, and a thin layer 46 of a dielectric material, such as glass, mica, or plastic. Electrode structure 40 comprises a glass dielectric substrate 48 that has deposited on its inner surface 50 column electrodes 18 of indium tin oxide, which is optically transparent, to form a striped pattern. Next adjacent ones of column electrodes 18 are spaced apart from each other by a distance 52, which specifies the horizontal space between next adjacent display elements 16 in a row.

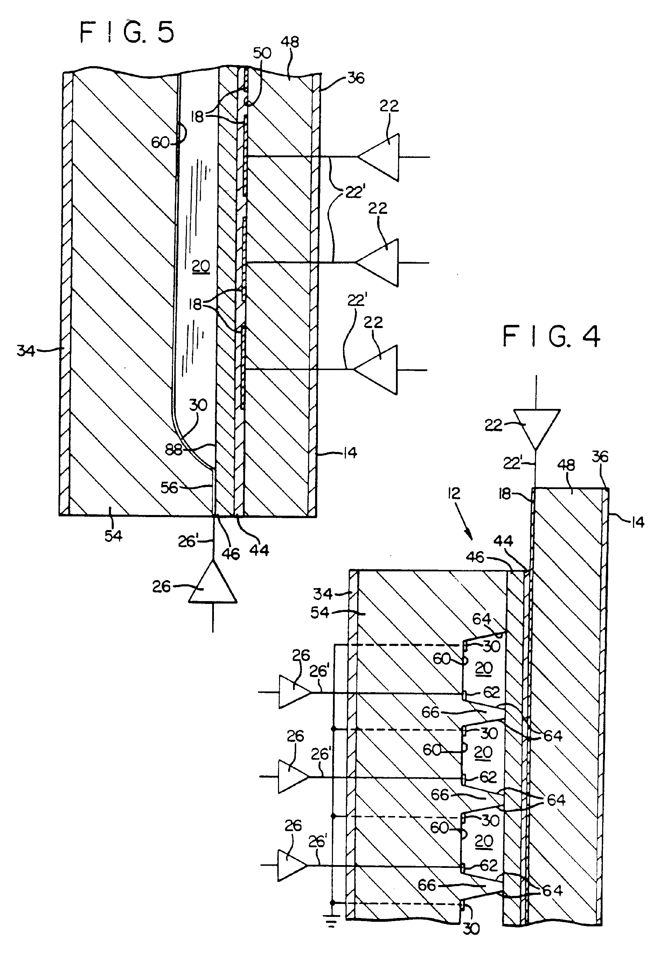

Electrode structure 42 comprises a glass dielectric substrate 54 into whose inner surface 56 multiple channels 20 of trapezoidal cross section are inscribed. Channels 20 have a depth 58 measured from inner surface 56 to a base portion 60. Each one of the channels 20 has a pair of thin, narrow nickel electrodes 30 and 62 extending along base portion 60 and a pair of inner side walls 64 diverging apart in the direction away from base portion 60 toward inner surface 56. The reference electrodes 30 of the channels 20 are connected to a common electrical reference potential, which can be fixed at ground potential as shown. The electrodes 62 of the channels 20 are connected to different ones of the output amplifiers 26 (of which three and five are shown in Fig. 2 and Fig. 3, respectively) of data strobe 28. (The electrodes 62 are hereinafter referred to as "row electrodes 62.") To ensure proper operation of the addressing structure, the reference electrodes 30 and row electrodes 62 are connected to the electrical reference potentials and the outputs 26′ of data strobe 28, respectively, on opposite sides of display panel 10, as shown in Figs. 4, 11A, and 11B.

The adjacent sidewalls 64 of next adjacent channels 20 define support structures 66 whose top surfaces 56 support layer 46 of the dielectric material. Next adjacent ones of channels 20 are spaced apart from each other by the width 68 of the top portion of each support structure 66, which width 68 defines the vertical space between next adjacent display elements 16 in a column. The overlapping regions 70 of column electrodes 18 and channels 20 define the display elements 16, which are shown in phantom in Figs. 2 and 3. Fig. 3 shows with better clarity the array of display elements 16 and the vertical and horizontal spacings between them.

The magnitude of the voltage applied to column electrodes 18 specifies the distance 52 to promote isolation of adjacent column electrodes 18. Distance 52 is typically much less than the width of column electrodes 18. The inclinations of adjacent side walls 64 of next adjacent channels 20 specify the distance 68, which is typically much less than the width of channels 20. The widths of the column electrodes 18 and the channels 20 are typically the same and are a function of the desired image resolution, which is specified by the display application. It is desirable to make distances 52 and 68 as small as possible. In current models of display panel 12, the channel depth 58 is one-half the channel width.

Each of the channels 20 is filled with an ionizable gas, preferably that includes helium gas, for reasons that will be explained below. Layer 46 of the dielectric material functions as an isolating barrier between the ionizable gas contained within channel 20 and layer 44 of the liquid crystal material. The absence of dielectric layer 46 would permit either the liquid crystal material to flow into the channel 20 or the ionizable gas to contaminate the liquid crystal material. Dielectric layer 46 may be eliminated from displays that employ a solid or encapsulated electro-optic material.

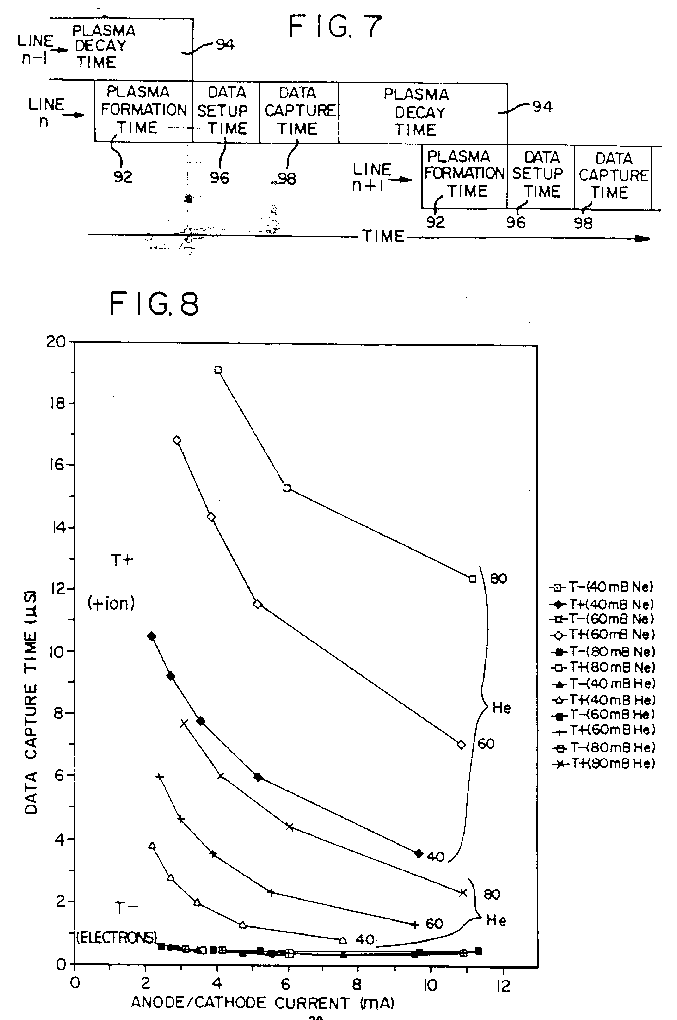

The principles underlying the operation of display panel 12 are that 1) each of its display elements 16 functions as a sampling capacitor for analog voltage data applied to the column electrode 18 forming a part of the display element and 2) the ionizable gas functions as a sampling switch. Fig. 6 is an equivalent circuit to which the following explanation of the operation of display system 10 refers.

With reference to Fig. 6, each of display elements 16 of display panel 12 can be modeled as a capacitor 80 (hereinafter "capacitor model 80"), whose top plate 82 represents one of the column electrodes 18 (Fig. 2) and whose bottom plate 86 represents the free surface 88 (Fig. 2) of layer 46 of the dielectric material. Capacitor model 80 represents the capacitive liquid crystal cell formed by an overlapping region of a column electrode 18 and a channel 20. The description herein of the operation of display system 10 refers to the capacitor model 80.

In accordance with the basic addressing procedure, data driver 24 captures a first line of data, which represents discrete samples of the time-varying voltage of the analog data signal in a time interval of predetermined duration. The sample of the magnitude of the data signal at a particular instance within the time interval represents the magnitude of the analog voltage applied to a capacitor model 80 in a corresponding column position of the row electrode 62 receiving a strobe pulse. Data driver 24 develops on its output amplifiers 22 the analog voltages that are applied to column electrodes 18. In Fig. 6, four exemplary output amplifiers 22 of data driver 24 deliver analog voltages of positive polarity with respect to reference electrode 30 to the respective ones of column electrodes 18 to which they are connected. The application of a positive voltage on a column electrode 18 induces on free surface 88 (Fig. 2) of layer 46 of the dielectric material a voltage that is essentially equal to the magnitude of the applied voltage. This causes no change in the potential difference across capacitor model 80 and is represented in Fig. 6 by a top plate 82 and a bottom plate 86 with white surfaces.

At this instance, the gas contained in a channel 20 is in a de-ionized state, and the analog voltage developed on plates 82 and 86 of capacitor model 80 is positive with respect to the voltage potential of reference electrode 30 in the channel. Whenever data strobe 28 develops a negative-going voltage pulse on the row electrode 62 positioned within a channel 20, the gas in the channel assumes an ionized state (i.e., becomes a plasma). The channel 20 whose row electrode receives the strobe pulse is represented in Fig. 6 in dark, thick lines. Under these conditions, the grounded reference electrode 30 and the strobed row electrode 62 function as an anode and a cathode, respectively, for the plasma contained within the channel.

The electrons in the plasma neutralize the induced positive voltage on the bottom plates 86 of capacitor models 80. The capacitor models 80 in the strobed row are charged with the data voltages applied across them. This condition is indicated in Fig. 6 by top plates 82 with white surfaces and bottom plates 86 with lined surfaces. Upon completion of the storage of the data voltages across capacitor models 80, data strobe 28 terminates the negative-going voltage pulse on the row electrode 62 of the strobed channel 20, thereby ending the strobe pulse and extinguishing the plasma.

Each of the row electrodes 62 is strobed in a similar manner until the entire display surface 14 is completely addressed and thereby stores an image field of data. The voltage remains stored across each of the capacitor models 80 in the strobed row for a time at least as long as the duration of the image field and is independent of subsequent changes in data voltage applied to top plate 82 of capacitor model 80. The voltage stored across each of the capacitor models 80 changes in accordance with the analog data voltages representing the display data of the next succeeding image field.

In a display system 10 whose image fields are in a noninterlaced format, the analog data voltages applied to column electrodes 18 in the next succeeding image field are of opposite polarity. Alternating between positive and negative polarities from one image field to the next image field provides a long term zero net DC voltage component, which is typically required for long term operation of liquid crystal materials. The liquid crystal material produces the gray scale effect in response to the root-mean-square (rms) value of the applied analog voltage data. The display image produced is, therefore, unaffected by alternate changes in polarity of the analog voltage data. In a display system 10 whose image fields are in an interlaced format, the analog data voltages applied to column 18 electrodes in next succeeding image frames are of opposite polarity to achieve the long term zero net DC voltage component. Each image frame includes two image fields of which each comprises one-half the number of addressable lines.

The description presented above indicates that the ionizable gas contained within each of the channels 20 operates as an electrical switch 90 whose contact position changes between binary switching states as a function of the voltage applied by data strobe 28. The switches 90 shown in Fig. 6 in the open position are connected to reference electrodes 30 and are driven by a strobe pulse applied to row electrodes 62. The absence of a strobe pulse allows the gas within the channels 20 to be in a de-ionized state and thereby be in a nonconducting state. The switches 90 shown in Fig. 6 in the closed position are connected to a reference electrode 30 and are driven by a strobe pulse that is applied to row electrode 64 and is of a magnitude that causes the gas within the channel 20 to be in an ionized state and thereby be in a conducting state. In Fig. 6, the amplifier 26 shown in the middle of the three output amplifiers 26 of data strobe 28 strobes a row of capacitor models 80 to establish and store the display data voltages across them.

To function as a switch, the ionizable gas contained within channels 20 underneath glass electrode structure 40 communicates with layer 46 of the dielectric material to provide an electrically conductive path from layer 46 of the dielectric material to reference electrode 30. The plasma in a channel 20 whose row electrode 62 receives a strobe pulse provides a ground path to the capacitor model 80 representing the portion of liquid crystal material positioned adjacent the plasma. This allows the capacitor models 80 to sample the analog data voltages applied to column electrodes 18. Extinguishing the plasma acts to remove the conducting path, thereby allowing the data sample to be held across the display element. The voltages remain stored across layer 44 of the liquid crystal material until voltages representing a new line of data in a subsequent image field are developed across the layer 44. The above-described addressing structure and technique provide signals of essentially 100% duty cycle to every one of the display elements 16.

Fig. 7 is a diagram showing the time constraints that limit the number of lines of data of which display system 10 is capable of addressing during an image field. With reference to Fig. 7, an exemplary line "n" of data requires time 92 for the plasma to form after the row of electrodes 62 of the strobed channel 20 receives a strobe pulse. The plasma formation time 92 may be substantially eliminated as a factor in limiting the number of addressable lines in an image field by initiating the strobe pulse in advance during the preceding line n-1. In the preferred embodiment, the plasma formation time 92 for helium gas is nominally 1.0 microsecond.

The data setup time 96 represents the time during which data driver 24 slews between the data values of two next adjacent lines of data and develops on output amplifiers 22 the analog voltage signals that are applied to column electrodes 18. The data setup time 96 is a function of the electronic circuitry used to implement data driver 24. A data setup time 96 of less than 1.0 microsecond is achievable.

The data capture time 98 depends on the conductivity of the ionizable gas contained within the channels 20. Fig. 8 is a graph showing the time for data capture 98 as a function of the plasma current flowing between reference electrode 30 and row electrode 62 in a channel 20. The curves in Fig. 8 represent the time required by a display element to acquire 90% of the voltage corresponding to a datum. Fig. 8 shows that the ions produced by a plasma comprised of helium gas exhibit a lower data capture time 98 than that of neon. The electron current in a plasma flows from the cathode (row electrode 62) to the anode (reference electrode 30).

A preferred operating point is that which provides the fastest data capture time 98 for positive ion current. In the particular case represented in Fig. 8, such an operating point can be achieved by using helium gas at a pressure of 40 millibars and a current of 7.5 milliamperes to produce a time 98 for data capture of about 0.5 microsecond. The reason helium provides a shorter data capture time 98 than that of neon is that helium is a lighter ion with greater mobility. Optimum values of pressure and current depend on the size and shape of channels 20.

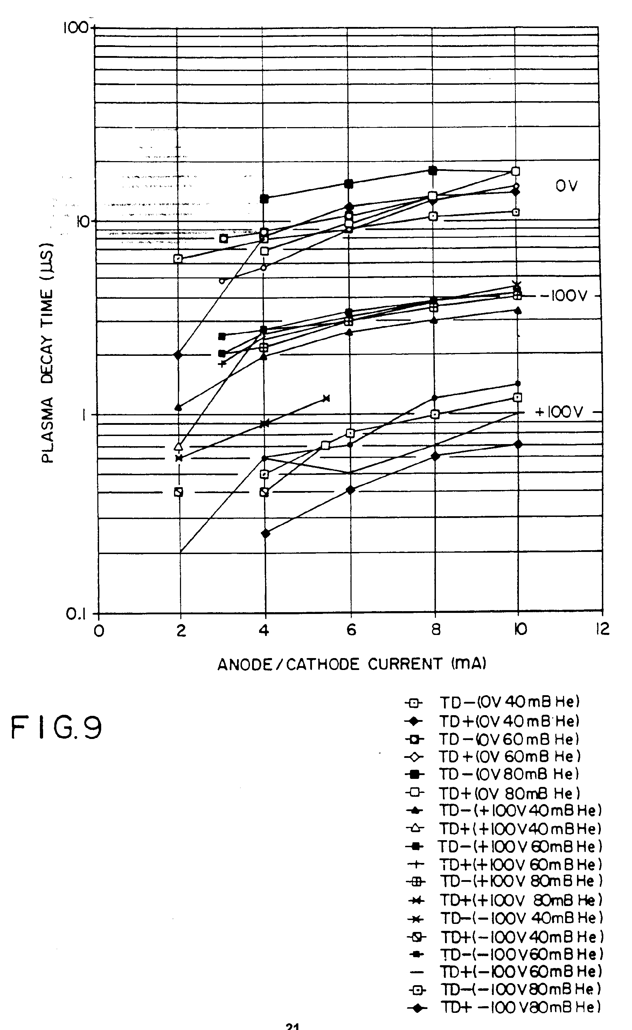

The plasma decay time 94 represents the time during which the plasma in channel 20 returns to a deionized state upon the removal of a strobe pulse from row electrode 62. Fig. 9 is a graph showing the plasma decay time beyond which no greater than 3% crosstalk will occur as a function of anode/cathode current in display panel 12. Fig. 9 shows that the plasma decay time 94 increases as a function of the current flowing through the plasma from row electrode 62 to reference electrode 30. The magnitude of the strobe pulse applied to row conductor 62 determines the amount of current flowing through the plasma. Fig. 9 indicates that decreased plasma decay times 94 can be achieved by applying a continuous bias voltage of about +100 volts, which is less than the voltage required to maintain the helium gas in its ionized state. Fig. 9 also indicates that a bias voltage of +100 volts would provide approximately a tenfold decrease in plasma decay time 94 relative to a bias voltage of zero volts.

The time required to address a line of data equals the sum of the data setup time 96, the data capture time 98, and the plasma decay time 94. The number of lines addressable during an image field equals the time duration of the image field divided by the time required to address a line of data. For noninterlaced 60 Hz frame rate applications, the number of lines of data display system 10 would appear to be capable of addressing exceeds 9,000 lines using the above-described simple addressing technique. It will be appreciated that the number of addressable lines of data is not the same as the resolution of display system 10. The resolution is a function of the widths of the channels 20 and the widths of the column electrodes 18.

The use of a priming technique is advantageous to ensure the ability to address a relatively large number of lines in an image frame. Priming entails the introduction of ions to initiate a gas discharge. Priming display system 10 can be accomplished by passing a current through a priming channel (not shown) which is orthogonally disposed to the channels 20 and in which each of the channels 20 terminates along one of the margins of display panel 12. Priming allows plasma formation without an initial statistical delay time that would otherwise unpredictably lengthen the plasma formation time.

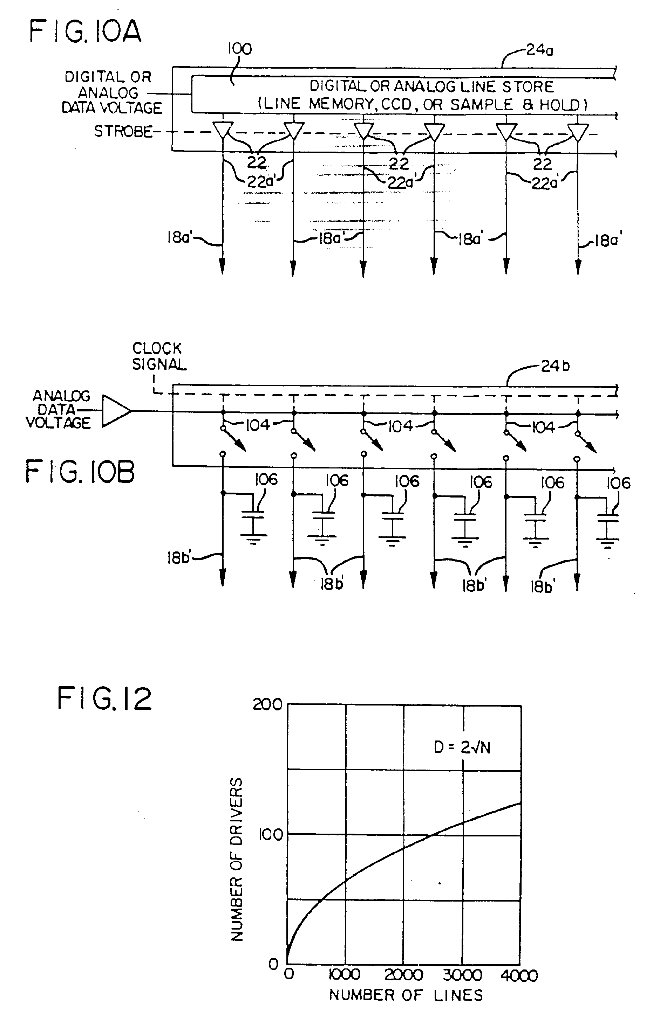

Figs. 10A and 10B show alternative circuit designs for the data drivers 24 whose corresponding components are identified by identical reference numerals with the suffixes "a" and "b", respectively.

With reference to Fig. 10A, data driver 24a samples the data signal and stores it in a buffer memory 100. The data signal can be in analog or digital form. Buffer memory 100 can be of the charge-coupled device (CCD) type or the sample-and-hold type to store an analog data signal, and buffer memory 100 can be of the digital type to store a digital data signal. The devices 22 represent either buffer amplifiers or digital-to-analog converters, depending on whether buffer memory 100 holds analog voltages or digital data, respectively. Devices 22 permit the parallel transfer of analog voltages to column electrodes 18a. Data driver 24a is capable of high-speed operation because CCD and sample-and-hold circuits are capable of high-speed acquisition and the analog voltages can be transferred simultaneously in parallel to the column electrodes 18a.

With reference to Fig. 10B, data driver 24b samples the analog data signal in serial fashion by sequentially closing and opening one at a time different ones of a set of switches 104. Each of the switches 104 is connected to a capacitor 106. The capacitors 106 accumulate charge from the data signal when the switch is closed. This provides analog voltage samples of the data signal to the column electrodes 18b in a row from one end to the other end. A sampling clock signal applied to the control electrodes of switches 104 sets the sampling rate. The data setup time 96 of the circuit of Fig. 10B is greater than that of the circuit of Fig. 10A by a multiplication factor equal to the number of column electrodes 18b.

To operate properly in display system 10, data driver 24b requires that the horizontal blanking time from row to row exceed the sum of the data capture time 98 and the plasma decay time 94.

Figs. 11A and 11B compare the number of data strobe outputs required for exemplary display panels 12 having nine channels whose reference electrodes 30 receive, respectively, a fixed reference voltage and the strobe signal pulses. The display panel 12 of Fig. 10A has its reference electrodes 30 connected to ground and nine different strobe output amplifiers 26, data strobe 28 driving different ones of row electrodes 62. The display panel 12 of Fig. 11B has its reference electrodes 30 grouped in first sets of three and its row electrodes 62 grouped in second sets of three. The channels 20 (Fig. 4) whose reference electrodes 30 together form any one of the first sets include no greater than one electrode 62 of any one of the second sets. Display system 10 strobes only one set of the first sets of reference electrodes 30 for a time interval of predetermined duration. During the strobe time interval, display system 10 addresses the display elements 16 by driving the column electrodes 18 and strobing the second set of row electrodes 62 included within the channels 20 whose reference electrodes 30 receive the strobe pulse. The row electrodes 62 of the channels 20 whose reference electrodes 30 do not receive a strobe pulse are, therefore, not activated.

This configuration of electrical connections of the output amplifiers 26 of data strobe 28 to the reference electrodes 30 and row electrodes 62 of channels 20 provides an addressing structure that requires fewer outputs 26 of the data strobe 28. In the exemplary display panel 12 of Fig. 11B, the number of data strobe output amplifiers 26 is reduced from nine to six.

Fig. 12 is a graph showing the minimum number of drivers required as a function of the number of addressable lines of data available with an addressing structure of the type implemented in the display panel 12 of Fig. 11B. Fig. 12 indicates that substantial reduction of drivers can be achieved for display systems having a relatively large number of addressable lines of data.

The addressing structure of the present invention is also amenable to the reduction of the number of drivers through the use of other techniques similar to the technique implemented in the Self-Scan™ displays developed by Burroughs. Such displays employ a display cell, which the viewer sees, and a scan cell, which the viewer does not see. The scan cells control the state of the display cells by sending active priming particles into a localized region of an ionizable gas. In a scan cell channel, a plasma discharge is moved sequentially adjacent each display cell and generates priming particles which activate the display cell adjacent to them.

In display panel 12, electrical segmentation of the orthogonal priming channel could provide a localized ion source that moves sequentially from one channel to the next. In lieu of the above-described technique, wall charge coupling or other known techniques could be employed to implement further driver reduction.

The addressing technique of applying data voltages of positive and negative polarities in alternate image fields is amenable to implementation in a display system 10 employing the driver reduction technique described with reference to Figs. 11B and 12. Alternative addressing techniques that apply data voltages of only positive polarity can further increase the addressing speed. These alternative techniques introduce an erase field upon the conclusion of each image field.

In one addressing technique of this type, during the erase field, data driver 24 applies a voltage of about ground potential to column electrodes 18 as data strobe 28 applies sequentially a positive pulse and a negative pulse of relatively short durations to row electrodes 62 of the channels 20. During application of the positive pulse, reference electrode 30 and row electrode 62 function as a cathode and an anode, respectively, of the plasma. Since the previously required data voltages were of positive polarity, any charge stored across a storage element 16 induces a negative charge on surface 88 of layer 46 of the dielectric material, which functions, therefore, as a cathode. A cathode is surrounded by a relatively large ion density, which rapidly neutralizes the negative charge on layer 46 of the dielectric material. The voltage on layer 46 may approach that of the anode and, therefore, can accumulate residual positive charge to a significant degree. During application of the negative pulse, the ground potential applied to column electrodes 18 resets the residual positive charge to ground in a manner similar to that effected during the writing of an image field.

If the positive pulse is not used, the speed of addressability is limited by the above-described positive ion charging phenomenon. This alternative addressing technique is not, however, amenable to the exact driver reduction techniques described with reference to Figs, 11B and 12.

In another addressing technique of this type, data strobe 28 applies a negative pulse to more than one (e.g., ten) row electrodes 62 to erase more than one line of data at a time. This technique would cause duty cycle nonuniformities of a small degree across display surface 14 of display panel 12.

Flat panel display system 10 can be modified to form a versatile analog data memory system 110 containing an array of memory elements, which represents a second embodiment that implements the addressing structure and carries out the method of the present invention. Such modifications include the removal of polarizing filters 34 and 36, if they are present, and layer 44 of liquid crystal material shown in Figs. 2, 4, and 5.

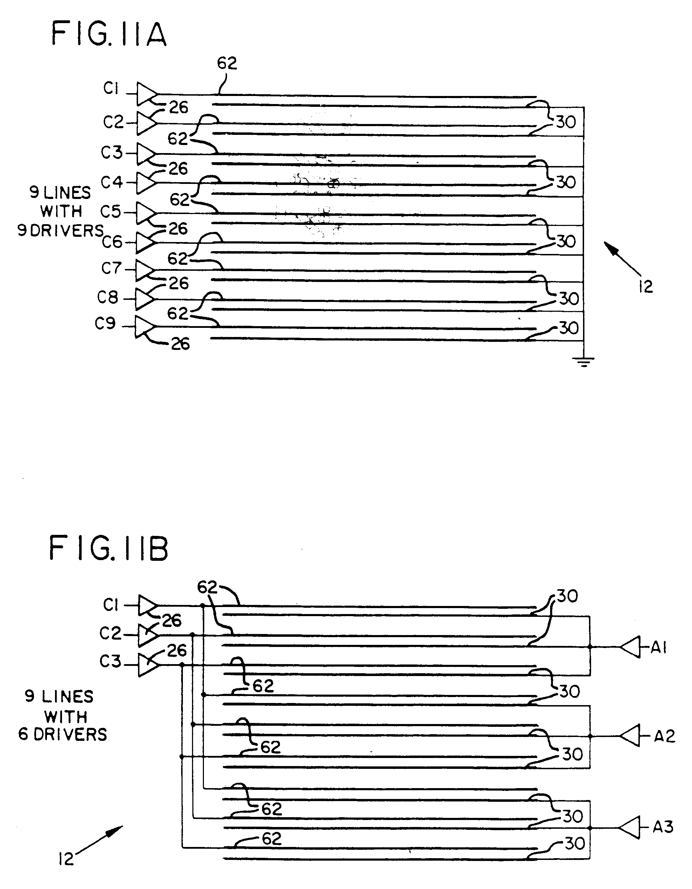

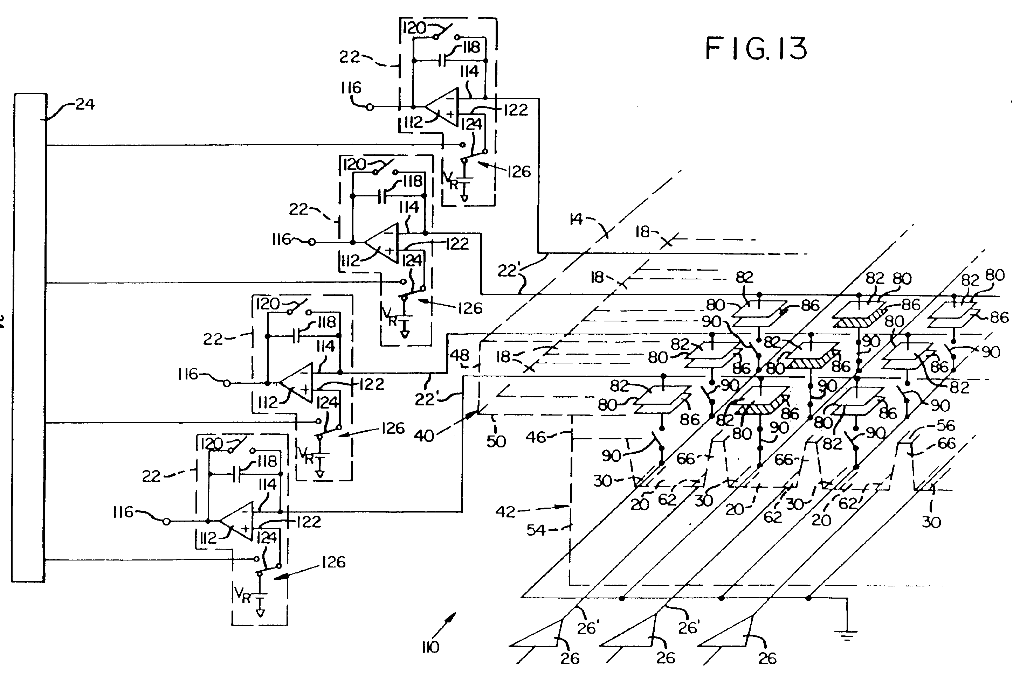

Fig. 13 shows the equivalent circuit for memory system 110. Except as indicated above, the systems of Figs. 6 and 13 are similar; therefore, corresponding components in Figs. 6 and 13 bear identical reference numerals. In memory system 110, dielectric 46 functions as the dielectric element of capacitor model 80, which represents a memory element. It will be appreciated that column electrodes 18 need not be formed of optically transparent material and may advantageously be formed of aluminum or other conductive material. The data drive output amplifiers 22 of memory system 110 comprise circuit elements that function as column electrode drive amplifiers in the data write mode and as column electrode sensing amplifiers in the data read mode. The data strobe output amplifiers 26 of the systems of Figs. 6 and 13 are similar.

With reference to Fig. 13, each of the output amplifiers 22 of data drive circuit 24 comprises a high-speed operational amplifier 112 that has connected between its inverting input terminal 114 and output terminal 116 a parallel combination including a feedback capacitor 118 and a switch element 120. Amplifier 112 is selectively configured as a voltage follower in the data write mode by actuating switch element 120 to its conducting state and as an integrator in the data read mode by actuating switch element 120 to its nonconducting state. The noninverting input terminal 122 of operational amplifier 112 is connected to the moveable contact terminal 124 of a switch element 126, which selectively connects noninverting input terminal 122 to either a reference voltage V_{R} or an output signal conductor of data drive circuit 24.

Whenever it is in the data write mode, output amplifier 22 delivers a data drive signal to the column electrode 18 forming a memory element of memory system 110. This is accomplished by configuring operational amplifier 112 as a voltage follower and positioning moveable contact terminal 124 of switch element 126 to deliver the data drive signal from data drive circuit 24 to noninverting input terminal 122 of operational amplifier 112. During this time, a row strobe pulse applied to row electrode 62 in the channel 20 forming the memory element 110 excites the ionizable gas contained in the channel to the ionized state, thereby developing a data voltage across capacitor model 80 in the manner as described above with reference to Fig. 6. The magnitude of the voltage across capacitor model 80 represents that of the data drive signal.

Whenever it is in the data read mode, data amplifier 22 senses the current in the column electrode 18 forming the memory element of memory system 110. This is accomplished by means of a two-step process.

First, moveable contact terminal 124 of switch element 126 is positioned to deliver voltage reference V_{R} to noninverting input terminal 122 of operational amplifier 112. During this time, the row strobe pulse is inactive to maintain the ionizable gas in a de-ionized state, thereby allowing the reference voltage V_{R} to be established on output terminal 116 of operational amplifier 112, column electrode 18, and upper plate 82 of capacitor model 80. The voltage across feedback capacitor 118 is thereby normalized to 0.0 volts. It will be appreciated, however, that memory system 110 can be configured to operate with an offset voltage between the inputs and outputs of each operational amplifier 112.

Second, after the voltage across feedback capacitor 118 stabilizes to 0.0 volts, operational amplifier 112 is configured as an integrator whose input terminal 114 is prepared to receive the current flowing from column electrode 18. The voltage difference between lower plate 86 of capacitor model 80 and reference electrode 30 is a function of V_{R} and the previously written data voltage across capacitor model 80. Whenever a row strobe pulse again excites the ionizable gas to its ionized state, lower plate 86 of capacitor model 80 is electrically connected to reference electrode 30, thereby changing the voltage across capacitor model 80. Operational amplifier 112 now configured as an integrator senses this change in voltage and provides on its output terminal 116 a voltage proportional to the data voltage previously developed across capacitor model 80.

There exist other alternatives for developing the data voltage cross capacitor model 80 to promote its function as a memory element. For example, substituting photoconductive material for the dielectric material of layer 46, using optically transparent column electrodes 18, and exposing memory system 110 to visible light would modulate the voltages across capacitor models 80 in proportion to the intensity of the light incident on memory system 110. The voltage change developed across capacitor model 80 in response to the intensity of incident light would be restored during the data read mode, as described above. The layer 46 of photoconductive material and optically transparent column electrodes 18 provide, therefore, an image sensing device with analog data memory properties.

In the above-described image sensing device, the construction of layer 46 of photoconductive material as multiple electrically isolated strips or discrete islands would avoid conduction between adjacent capacitor models 80. Constructing a strip of metal or other conductive material along the margin of the optically transparent electrodes would increase efficiency of data collection in the data read mode by decreasing the time required to read out the data voltage developed across capacitor models 80.

The above-described image sensing device uses the photoconductive properties of layer 46 of photoconductive material during the period between the data read modes. It is also possible to make direct use of the photoconductive properties of layer 46, in which case the storage element 16 might be more properly characterized as a "sensing" element and capacitor model 80 would be more properly depicted as an electrical current modulating device. This can be accomplished by applying to column electrode 18 a voltage that establishes a voltage gradient across layer 46 during the time a row strobe pulse is applied between strobe electrode 62 and reference electrode 30. The electrical current flowing from reference electrode 30, through layer 46 and column electrode 18, to output terminal 116 of operational amplifier would constitute the output signal. Replacing feedback capacitor 118 with a resistor would make the voltage appearing on output terminal 116 of operational amplifier 112 proportional to the current flowing through layer 46.

It will be obvious to those having ordinary skill in the art that many changes may be made to the details of the above-described preferred embodiment of the present invention without departing from the underlying principles thereof. The scope of the present invention should be determined, therefore, only by the following claims.

## Claims

1. An addressing structure for a data storage element (16; 80), comprising:
an ionizable gaseous medium adapted for communication with the data storage element and an electrical reference electrode (30) positioned within the gaseous medium; and
ionizing means for selectively effecting ionization of the ionizable gaseous medium to provide an interruptible electrical connection (90) between the data storage element and the electrical reference electrode, thereby to selectively address the data storage element, characterised in that the ionizing means comprises an ionizing electrode (62) positioned adjacent the reference electrode within the gaseous medium, whereby ionization of the gaseous medium is effected by application of a signal between the ionizing electrode and the reference electrode.

2. An addressable system having an addressing structure as claimed in claim 1, including a plurality of said data storage elements (16; 80) comprised of dielectric material (46; 44) and arranged in an array on a surface (48), the data storage elements being electrically responsive to data drive (24) and data strobe (28) circuits that provide respective data drive and data strobe signals, the addressing structure being arranged to select and store data across the dielectric material at the location of at least one of said elements, comprising:
an enclosed volume (20) containing said ionizable gaseous medium and said ionizing (62) and reference (30) electrodes, the ionizable gaseous medium being responsive to the data strobe signal applied across the ionizing and reference electrodes to effect a change in said at least one element, whereby the data strobe signal places the ionizable gaseous medium in an ionized state to develop across the element a potential difference corresponding to the magnitude of the data drive signal and independent of the magnitude of the data strobe signal to effect the change.

3. A system as claimed in claim 2, in which the data drive circuit (24) includes a data electrode (18) positioned adjacent a surface of the dielectric material (46; 44) for receiving the data drive signal, the reference electrode (30) being connected to an electrical reference potential.

4. A system as claimed in claim 2 or 3, in which the dielectric material includes an electro-optic material (44).

5. The system as claimed in claim 4 in which the electro-optic material (44) is of the liquid crystal type.

6. A system as claimed in claim 4 or 5 in which the dielectric material (44) is arranged to isolate the electro-optic material (46) from the ionizable gaseous medium.

7. A system as claimed in any one of claims 2 to 6 in which the ionizable gaseous medium comprises helium.

8. An addressable system having a plurality of data storage elements (16; 80), comprising:
a first substrate (48) supporting on a major surface thereof a plurality of non-overlapping first electrodes (18) that extend in a first direction;
a second substrate (54) having a plurality of non-overlapping channels (20) that extend along a major surface thereof in a second direction, each of the channels comprising an addressing structure as claimed in claim 1, containing said ionizable gaseous medium and having said ionizing (62) and reference (30) electrodes extending along a substantial portion of the length of the channel,
the first and second substrates being disposed face-to-face and spaced-apart with the first direction transverse to the second direction to define overlapping regions (16) of the first electrodes and the channels;
a layer of material (46; 44) having dielectric properties positioned between the first and second substrates, the layer of dielectric material and the overlapping regions defining said plurality of data storage elements; and
first means (24) for applying first electrical signals to the first electrodes and second means (28) for applying second electrical signals to the ionizing electrodes, the application of the second electrical signals to selected ones of the ionizing electrodes effecting ionization of the gaseous medium associated with the storage elements selected according to the selected ones of the ionizing electrodes and the simultaneous application of the first electrical signals to selected ones of the first electrodes changing the charge in the storage elements in response to the first electrical signals.

9. A system as claimed in claim 8, in which each of the channels (20) defines a row of the storage elements (16; 80) and each of the first electrodes (18) defines a column of the storage elements, and which further comprises means (32) for coordinating the functions of the first and second means (24, 28) for applying the respective first and second electrical signals so that the second means applies the second electrical signal to the ionizing electrode (62) of a row of storage elements during the time when the first means applies the first electrical signals to the columns of storage elements, thereby to change the charges of the storage elements in a row in response to the first electrical signals.

10. A system as claimed in claim 8 or 9, in which the first (24) and second means (28) provide in each of successive first and second image fields the simultaneous application of the first and second electrical signals only once to each of the storage elements (16; 80), the first electrical signals of the first image field being of opposite polarity to that of the second image field.

11. A system as claimed in any one of claims 8 to 10 in which the dielectric layer includes an electro-optic material (44) such that the change in the charge in the storage elements (16; 80) changes a property of the electro-optic material.

12. A system as claimed in claim 8, in which groups of the ionizing electrodes (62) are connected together to receive a common one of said second electrical signals and groups of the reference electrodes (30) are connected together to receive a common strobe signal, wherein for any one group of ionizing electrodes and any one group of reference electrodes, no more than one of said channels (20) contains an ionizing electrode from said one group and a reference electrode from said one group.

13. A method of addressing a data element (16; 80), comprising:
positioning an electrical reference electrode (30) and an ionizing electrode (62) within an ionizable gaseous medium; and
providing an interruptible electrical connection between the electrical reference electrode and the data element by selectively effecting ionization of an ionizable gaseous medium in communication with the data element, the ionization of the gaseous medium developing an electrical conduction path (90) through the gaseous medium to the electrical reference electrode to address the data element to which a datum corresponds, characterised in that the ionization is effected by selectively applying a signal between said ionizing and reference electrodes.

14. A method of addressing a data element (16; 80) as claimed in claim 13, the data element including a layer (46; 44) of dielectric material, further comprising:
inducing on a major surface of the layer a signal corresponding to the data whereby the development of the conduction path (90) effects storage of the signal by the storage element and thereby changes the charge in the data element in accordance with the data.

15. A method as claimed in claim 14, further comprising effecting de-ionization of the ionizable gaseous medium to maintain the charge in the data element (16; 80).

16. A method as claimed in claim 15 in which the deionization is effected by applying between the electrical reference electrode (30) and the ionizing electrode (62) within the ionizable gaseous medium a signal such as to cause de-ionization of the ionizable gaseous medium and electric current flow between the ionizing electrode and the electrical reference electrode, thereby to reduce the decay time of the ionizable gaseous medium from ionization to deionization.

17. A method as claimed in any one of claims 14 to 16, wherein said dielectric layer (46; 44) includes a layer (44) having electro-optic properties, wherein the step of changing the charge in the data element (16; 80) changes a property of the electro-optic layer.

## Patentansprüche

1. Aufbau zur Adressierung eines Datenspeicherelementes (16; 80), mit:
einem ionisierbaren gasförmigen Medium, das zur Kommunikation mit dem Datenspeicherelement ausgelegt ist, und einer in diesem gasförmigen Medium angeordneten elektrischen Referenzelektrode (30); und
einer Ionisiervorrichtung zur selektiven Durchführung der Ionisierung des ionisierbaren gasförmigen Mediums, um eine unterbrechbare elektrische Verbindung (90) zwischen dem Datenspeicherelement und der elektrischen Referenzelektrode zu erzeugen, wodurch das Datenspeicherelement selektiv adressiert wird, dadurch gekennzeichnet, daß die Ionisiervorrichtung eine Ionisierelektrode (62) umfaßt, welche in der Nähe der Referenzelektrode im gasförmigen Medium angeordnet ist, wodurch die Ionisierung des gasförmigen Mediums durch Anlegen eines Signals zwischen der Ionisierelektrode und der Referenzelektrode erfolgt.

2. Adressierbares System mit einem Adressieraufbau nach Anspruch 1, das eine Vielzahl dieser Datenspeicherelemente (16; 80) aufweist, die aus dielektrischem Material (46; 44) hergestellt und in einem Feld auf einer Oberfläche (48) angeordnet sind, wobei die Datenspeicherelemente elektrisch auf Datentreib- (24) und Datenfreigabe- (28) Schaltungen ansprechen, die jeweils Datentreib- bzw. Datenfreigabesignale bereitstellen, wobei der Adressieraufbau so angeordnet ist, daß er Daten auswählt und diese an der Stelle wenigstens eines dieser Elemente auf dem dielektrischen Material speichert, mit:
einem eingeschlossenen Volumen (20), das das ionisierbare gasförmige Medium sowie die Ionisier- (62) und die Referenzelektrode (30) enthält, wobei das ionisierbare gasförmige Medium auf das Datenfreigabesignal anspricht, welches an die Ionisier- und Referenzelektrode angelegt wird, um eine Veränderung in dem wenigstens einen Element zu bewirken, wodurch das Datenfreigabesignal das ionisierbare gasförmige Medium in einen ionisierten Zustand versetzt, um über dem Element eine Potentialdifferenz zu entwickeln, die der Größe des Datentreibsignals entspricht und unabhängig von der Größe des Datenfreigabesignals ist, um die Veränderung zu bewirken.

3. System nach Anspruch 2, worin die Datentreibschaltung (24) eine Datenelektrode (18) aufweist, die in der Nähe einer Oberfläche des dielektrischen Materials (46; 44) angeordnet ist, um das Datentreibsignal zu empfangen, wobei die Referenzelektrode (30) an ein elektrisches Referenzpotential angeschlossen ist.

4. System nach Anspruch 2 oder 3, bei dem das dielektrische Material ein elektrooptisches Material (44) enthält.

5. System nach Anspruch 4, bei dem das elektrooptische Material (44) Flüssigkristall ist.

6. System nach Anspruch 4 oder 5, bei dem das dielektrische Material (44) so angeordnet ist, daß es das elektrooptische Material (46) gegenüber dem ionisierbaren gasförmigen Medium isoliert.

7. System nach einem der Ansprüche 2 bis 6, bei dem das ionisierbare gasförmige Medium Helium umfaßt.

8. Adressierbares System mit einer Vielzahl von Datenspeicherelementen (16; 80), mit:
einem ersten Substrat (48), das auf seiner Hauptoberfläche eine Vielzahl sich nicht überschneidender erster Elektroden (18) trägt, die in eine erste Richtung verlaufen;
einem zweiten Substrat (54) mit einer Vielzahl sich nicht überschneidender Kanäle (20), die auf einer Hauptoberfläche des Substrats (54) in einer zweiten Richtung verlaufen, wobei jeder der Kanäle einen Adressieraufbau nach Anspruch 1 umfaßt, der das ionisierbare gasförmige Medium enthält und bei dem die Ionisier- (62) und Referenz-Elektroden (30) entlang eines wesentlichen Abschnittes der Länge des Kanals verlaufen,
wobei das erste und das zweite Substrat mit einander zugewandten Flächen und voneinander beabstandet angeordnet sind, wobei die erste Richtung quer zur zweiten Richtung verläuft, so daß sich überschneidende Bereiche (16) der ersten Elektroden und der Kanäle ergeben;
einer Schicht aus Material (46; 44) mit dielektrischen Eigenschaften, die zwischen dem ersten und dem zweiten Substrat angeordnet ist, wobei die Schicht aus dielektrischem Material und die sich überschneidenden Bereiche die Vielzahl von Datenspeicherelementen ergeben; und
einer ersten Vorrichtung (24) zum Anlegen erster elektrischer Signale an die ersten Elektroden, und einer zweiten Vorrichtung (28) zum Anlegen zweiter elektrischer Signale an die Ionisierelektroden, wobei durch das Anlegen der zweiten elektrischen Signale an ausgewählte der Ionisierelektroden die Ionisierung des zu den Speicherelementen gehörigen gasförmigen Mediums bewirkt wird, wobei diese Speicherelemente gemäß den ausgewählten der Ionisierelektroden ausgewählt wurden, und durch das gleichzeitige Anlegen der ersten elektrischen Signale an ausgewählte der ersten Elektroden die Ladung in den Speicherelementen als Reaktion auf die ersten elektrischen Signale verändert wird.

9. System nach Anspruch 8, wobei jeder der Kanäle (20) eine Reihe der Speicherelemente (16; 80) bildet und jede der ersten Elektroden (18) eine Spalte der Speicherelemente bildet, und welches des weiteren eine Vorrichtung (32) zum Koordinieren der Funktionen der ersten und der zweiten Vorrichtung (24, 28) zum Anlegen jeweils der ersten bzw. der zweiten elektrischen Signale umfaßt, so daß die zweite Vorrichtung das zweite elektrische Signal an die Ionisierelektrode (62) einer Reihe von Speicherelementen während der Zeit anlegt, während der die erste Vorrichtung die ersten elektrischen Signale an die Spalten von Speicherelementen anlegt, wodurch die Ladungen der Speicherelemente in einer Reihe als Reaktion auf die ersten elektrischen Signale verändert werden.

10. System nach Anspruch 8 oder 9, worin die erste (24) und die zweite Vorrichtung (28) in jedem aufeinanderfolgender erster und zweiter Bildfelder das gleichzeitige Anlegen der ersten und zweiten elektrischen Signale nur einmal an jedes der Speicherelemente (16, 80) bewirken, wobei die ersten elektrischen Signale des ersten Bildfeldes von entgegengesetzter Polarität als die des zweiten Bildfeldes sind.

11. System nach einem der Ansprüche 8 bis 10, worin die dielektrische Schicht ein elektrooptisches Material (44) aufweist, so daß die Ladungsveränderung in den Speicherelementen (16; 80) eine Eigenschaft des elektrooptischen Materials verändert.

12. System nach Anspruch 8, bei dem Gruppen der Ionisierelektroden (62) miteinander verbunden sind, um ein gemeinsames der zweiten elektrischen Signale zu empfangen, und Gruppen der Referenzelektroden (30) miteinander verbunden sind, um ein gemeinsames Freigabesignal zu empfangen, worin für jede beliebige Gruppe von Ionisierelektroden und jede beliebige Gruppe von Referenzelektroden nicht mehr als einer der Kanäle (20) eine Ionisierelektrode aus der einen Gruppe und eine Referenzelektrode aus der einen Gruppe enthält.

13. Verfahren zur Adressierung eines Datenelementes (16; 80), mit folgenden Schritten:
Anordnen einer elektrischen Referenzelektrode (30) und einer ionisierenden Elektrode (62) in einem ionisierbaren gasförmigen Medium; und
Bereitstellen einer unterbrechbaren elektrischen Verbindung zwischen der elektrischen Referenzelektrode und dem Datenelement, indem die Ionisierung eines ionisierbaren gasförmigen Mediums, welches mit dem Datenelement kommuniziert, selektiv bewirkt wird, wobei durch die Ionisierung des gasförmigen Mediums eine elektrische Leiterbahn (90) durch das gasförmige Medium zu der elektrischen Referenzelektrode hin gebildet wird, um das Datenelement zu adressieren, mit dem eine Angabe korrespondiert, dadurch gekennzeichnet, daß die Ionisierung durch das selektive Anlegen eines Signals zwischen der Ionisier- und der Referenzelektrode erfolgt.

14. Verfahren zur Adressierung eines Datenelementes (16; 80) nach Anspruch 13, wobei das Datenelement eine Schicht (46; 44) aus dielektrischem Material aufweist, mit den weiteren Schritten:
Induzieren eines Signals auf einer Hauptoberfläche der Schicht, welches den Daten entspricht, wodurch die Entwicklung der Leiterbahn (90) das Speichern des Signals durch das Speicherelement bewirkt und dadurch die Ladung in dem Datenelement gemäß den Daten verändert.

15. Verfahren nach Anspruch 14, des weiteren umfassend das Bewirken der Deionisierung des ionisierbaren gasförmigen Mediums, um die Ladung im Datenelement (16; 80) beizubehalten.

16. Verfahren nach Anspruch 15, bei dem die Deionisierung durch Anlegen eines Signals zwischen der elektrischen Referenzelektrode (30) und der Ionisierelektrode (62) innerhalb des ionisierbaren gasförmigen Mediums derart erfolgt, um die Deionisierung des ionisierbaren gasförmigen Mediums und das Fließen eines elektrischen Stroms zwischen der Ionisierelektrode und der elektrischen Referenzelektrode zu bewirken, wodurch die Abfallzeit des ionisierbaren gasförmigen Mediums von der Ionisierung zur Deionisierung verringert wird.

17. Verfahren nach einem der Ansprüche 14 bis 16, worin die dielektrische Schicht (46; 44) eine Schicht (44) mit elektrooptischen Eigenschaften aufweist, wobei der Schritt des Veränderns der Ladung im Datenelement (16; 80) eine Eigenschaft der elektrooptischen Schicht verändert.

## Revendications

1. Structure d'adressage pour un élément de stockage de données (16 ; 80), comprenant :
un milieu gazeux pouvant être ionisé conçu pour communiquer avec l'élément de stockage de données et une électrode de référence électrique (30) positionnée à l'intérieur du milieu gazeux ; et
un moyen d'ionisation pour effectuer, de manière sélective l'ionisation du milieu gazeux pouvant être ionisé pour réaliser une connexion électrique pouvant être interrompue (90) entre l'élément de stockage de données et l'électrode de référence électrique, pour adresser, de ce fait, l'élément de stockage de données, de manière sélective, caractérisé en ce que le moyen d'ionisation comprend une électrode d'ionisation (62) positionnée à côté de l'électrode de référence à l'intérieur du milieu gazeux, de sorte que l'ionisation du milieu gazeux est effectuée par l'application d'un signal entre l'électrode d'ionisation et l'électrode de référence.

2. Système d'adressage ayant une structure d'adressage selon la revendication 1, incluant une pluralité desdits éléments de stockage de données (16 ; 80) composés d'un corps diélectrique (46 ; 44) et agencés en une matrice sur une surface (48), les éléments de stockage de données étant électriquement sensibles au circuit de pilotage de données (24) et au circuit d'activation de données (28) qui fournissent des signaux d'activation de données et de pilotage de données respectifs, la structure d'adressage étant agencée pour sélectionner et stocker des données aux bornes du corps diélectrique, à l'emplacement d'au moins un desdits éléments, comprenant :
un volume enfermé (20) contenant ledit milieu gazeux pouvant être ionisé et lesdites électrodes d'ionisation (62) et de référence (30), le milieu gazeux pouvant être ionisé étant sensible au signal d'activation de données appliqué aux bornes des enregistrements d'ionisation et de référence pour effectuer une modification dans au moins un dit élément, de sorte que le signal d'activation de données place le milieu gazeux pouvant être ionisé dans un état ionisé pour développer, aux bornes de l'élément, une différence de potentiel correspondant à l'amplitude du signal de pilotage de données et indépendante de l'amplitude du signal d'activation de données pour effectuer la modification.

3. Système selon la revendication 2, dans lequel le circuit de pilotage de données (24) comprend une électrode de données (18) positionnée à côté d'une surface du corps diélectrique (46 ; 44) pour recevoir le signal de pilotage de données, l'électrode de référence (30) étant reliée à un potentiel de référence électrique.

4. Système selon la revendication 2 ou 3, dans lequel le corps diélectrique comprend une matière électro-optique (44).

5. Système selon la revendication 4, dans lequel la matière électro-optique (44) est du type à cristaux liquides.

6. Système selon la revendication 4 ou 5, dans lequel le corps diélectrique (44) est agencé pour isoler la matière électro-optique (46) du milieu gazeux pouvant être ionisé.

7. Système selon l'une quelconque des revendications précédentes 2 à 6, dans lequel le milieu gazeux pouvant être ionisé est constitué d'hélium.

8. Système adressable ayant une pluralité d'éléments de stockage de données (16 ; 80), comprenant :
un premier substrat (48) supportant, sur une de ses surfaces principales, une pluralité de premières électrodes ne se chevauchant pas (18) qui s'étendent dans une première direction ;
un second substrat (54) ayant une pluralité de canaux ne se chevauchant pas (20) qui s'étendent le long d'une surface principale de ce dernier dans une seconde direction, chacun des canaux comprenant une structure d'adressage selon la revendication 1, contenant ledit milieu gazeux pouvant être ionisé et ayant lesdites électrodes d'ionisation (62) et de référence (30) s'étendant le long d'une importante partie de la longueur du canal,
les premier et second substrats étant disposés face à face et écartés, la première direction étant transversale par rapport à la seconde direction pour définir des zones se chevauchant (16) des premières électrodes et des canaux ;
une couche de matière (46 ; 44) ayant des propriétés diélectriques positionnée entre les premier et second substrats, la couche du corps diélectrique et les zones se chevauchant définissant ladite pluralité des éléments de stockage de données ; et
un premier moyen (24) pour appliquer des premiers signaux électriques aux premières électrodes et un second moyen (28) pour appliquer des seconds signaux électriques aux électrodes d'ionisation, l'application des seconds signaux électriques à des électrodes sélectionnées des électrodes d'ionisation effectuant l'ionisation du milieu gazeux associé aux éléments de stockage sélectionnés selon les électrodes sélectionnées des électrodes d'ionisation et l'application simultanée des premiers signaux électriques aux électrodes sélectionnées des premières électrodes modifiant la charge des éléments de stockage en réponse aux premiers signaux électriques.

9. Système selon la revendication 8, dans lequel chacun des canaux (20) définit une ligne d'éléments de stockage (16 ; 80) et dans lequel chacune des premières électrodes (18) définit une colonne des éléments de stockage, et qui comprend, de plus, un moyen (32) pour coordonner les fonctions des premier et second moyens (24, 28) pour appliquer les premiers et seconds signaux électriques respectifs de sorte que le second moyen applique le second signal électrique à l'électrode d'ionisation (62) d'une ligne d'éléments de stockage pendant le temps durant lequel le premier moyen applique les premiers signaux électriques aux colonnes des éléments de stockage, pour modifier, de ce fait, les charges des éléments de stockage dans une ligne en réponse aux premiers signaux électriques.

10. Système selon la revendication 8 ou 9, dans lequel les premier (24) et second (28) moyens réalisent dans chacune des première et seconde trames d'image successives l'application simultanée des premiers et seconds signaux électriques seulement une fois à chacun des éléments de stockage (16 ; 80), les premiers signaux électriques de la première trame d'image étant de polarité opposée à celle de la seconde trame d'image.

11. Système selon l'une quelconque des revendications 8 à 10, dans lequel la couche diélectrique comprend une matière électro-optique (44) de sorte que la modification de la charge des éléments de stockage (16 80) modifie une propriété de la matière électro-optique.

12. Système selon la revendication 8, dans lequel des groupes d'électrodes d'ionisation (62) sont reliés ensemble pour recevoir un signal électrique commun desdits seconds signaux électriques et dans lequel des groupes des électrodes de référence (30) sont reliés ensemble pour recevoir un signal d'activation commun, dans lequel, pour l'un quelconque groupe particulier des électrodes d'ionisation et pour l'un quelconque groupe particulier des électrodes de référence, pas plus d'un desdits canaux (20) contient une électrode d'ionisation dudit groupe particulier et une électrode de référence dudit groupe particulier.

13. Procédé d'adressage d'un élément de données (16 ; 80), comprenant :
le positionnement d'une électrode de référence électrique (30) et d'une électrode d'ionisation (62) à l'intérieur d'un milieu gazeux pouvant être ionisé ; et
la réalisation d'une connexion électrique pouvant être interrompue entre l'électrode de référence électrique et l'élément de données en effectuant l'ionisation, de manière sélective, d'un milieu gazeux pouvant être ionisé communiquant avec l'élément de données, l'ionisation du milieu gazeux développant un chemin de conduction électrique (90) à travers le milieu gazeux jusqu'à l'électrode de référence électrique pour adresser l'élément de données auquel une donnée correspond, caractérisé en ce que l'ionisation est effectuée en appliquant, de manière sélective, un signal entre lesdites électrodes d'ionisation et de référence.

14. Procédé d'adressage d'un élément de données (16 ; 80) selon la revendication 13, l'élément de données incluant une couche (46 44) de corps diélectrique, comprenant, de plus :
l'induction, sur une surface principale de la couche, d'un signal correspondant aux données, de sorte que le développement du chemin de conduction (90) effectue le stockage du signal par l'élément de stockage et modifie, de ce fait, la charge dans l'élément de données selon les données.

15. Procédé selon la revendication 14, comprenant, de plus, l'exécution de la désionisation du milieu gazeux pouvant être ionisé pour maintenir la charge dans l'élément de données (16 ; 80).

16. Procédé selon la revendication 15, dans lequel la désionisation est effectuée en appliquant un signal entre l'électrode de référence électrique (30) et l'électrode d'ionisation (62) à l'intérieur du milieu gazeux pouvant être ionisé, de façon à provoquer la désionisation du milieu gazeux pouvant être ionisé et l'écoulement d'un courant électrique entre l'électrode d'ionisation et l'électrode de référence électrique, pour réduire, de ce fait, le temps de décroissance du milieu gazeux pouvant être ionisé de l'ionisation à la désionisation.

17. Procédé selon l'une quelconque des revendications 14 à 16, dans lequel ladite couche diélectrique (46 ; 44) comprend une couche (44) ayant des propriétés électro-optiques, dans lequel l'étape de modification de la charge de l'élément de données (16 80) modifie une propriété de la couche électro-optique.
